(19) Europäisches Patentamt

European Patent Office

Office européen des brevets

(11) **EP 1 071 211 B1**

(12) **EUROPEAN PATENT SPECIFICATION**

(45) Date of publication and mention
of the grant of the patent:
**13.09.2006 Bulletin 2006/37**

(51) Int Cl.:
*H03K 17/06* (2006.01)  *H03K 17/30* (2006.01)

(21) Application number: **99830467.9**

(22) Date of filing: **21.07.1999**

(54) **Threshold voltage reduction of transistor shaped like a diode**

Schwellwertreduzierung eines als Diode geschalteten Transistors

Réduction de tension de seuil d'un transistor monté en diode

(84) Designated Contracting States:
**DE FR GB IT**

(43) Date of publication of application:
**24.01.2001 Bulletin 2001/04**

(73) Proprietor: **STMicroelectronics S.r.l.**
**20041 Agrate Brianza (Milano) (IT)**

(72) Inventors:
• **Bedarida, Lorenzo**
  **20059 Vimercate (MI) (IT)**
• **Disegni, Fabio**
  **13100 Aix en Provence (FR)**

• **Dima, Vincenzo**
  **20052 Monza (IT)**
• **Bartoli, Simone**
  **20040 Cambiago (MI) (IT)**

(74) Representative: **Mittler, Enrico et al**
**Mittler & C. s.r.l.,**
**Viale Lombardia, 20**
**20131 Milano (IT)**

(56) References cited:
**DE-C- 19 629 056**     **US-A- 4 139 935**
**US-A- 4 365 316**      **US-A- 4 417 164**
**US-A- 5 506 527**

**Description**

The present invention refers to a circuit disposal of a transistor shaped like a diode, in particular to a disposal able to reduce the threshold voltage of the transistor.

Moreover, the present invention refers to a method for reducing the threshold voltage of the transistor.

The market requests press toward the planning of devices working with supply voltage lower and lower.

One of the greater planning limitation is that related to the threshold voltage of the MOS transistors. The threshold voltage of a transistor depends on the minimum voltage achieved with the kind of the building process utilised.

In particular, the threshold voltage of the transistors used shaped like a diode, seen the wide utilisation of such configuration in the integrated circuit, represents a big limit for all the circuit family such as the current mirror, the sense amplifier and the charge pump.

At the decreasing of the supply voltage a lot of the classic structures of such kind, that uses transistors shaped like a diode, cannot work in a proper way any more.

US 5506527 discloses a low power diode having a comparator for compaiing the voltages present at the cathode and at the anode of the diode. When the comparator determined that the voltage at the anode is equal to or higher than the voltage at the cathode by a prefixed forward voltage, a signal is generated that turns on a transistor having the no drivable terminals connected with the anode and with the cathode.

US 4417164 discloses an apparatus comprising a MOSFEI and a sensing comparator having the inputs coupled with the source and drain terminals of the MOSFEI and the output coupled with the gate terminal of the MOSFEI The last is turned on or off respectively if the voltage between the drain and source terminals is higher or lower than a threshold value.

US 4365316 discloses a multifunction terminal circuit having an optional circuit, a signal terminal connected with the optional circuit, an unidirectional conductor means connected to the signal terminal and a circuit means whose coupling node is coupled with the signal terminal through the unidirectional conductor means. The circuit means determines a conduction state of the unidirectional conductor means in accordance with a potential difference between the signal terminal and the coupling node.

The aim of the present invention has been of reducing the threshold voltage of the used transistors shaped like a diode.

The basic idea to reach such aim has been that of reducing the threshold voltage of a transistor applying a voltage generator in series to the control terminal of said transistor in a way that the difference of the transistor threshold voltage and of the voltage generator is lesser than the threshold voltage of the transistor

From a general point of view this invention refers to a nMOS or pMOS transistor whose gate voltage is increased (for the nMOS transistors) or decreased (for the pMOS transistor) by using a circuit in series to the gate that provides an opportune delta of voltage.

According to a first aspect the present invention refers to a circuit disposal as defined in claim 1.

According to a second aspect the present invention refers to a method for reducing the threshold voltage of a transistor as defined in claim 4.

Further features and details of the present invention are reported in the dependent claims

Achieving a circuit disposal able to reduce to a prefixed value the threshold voltage of the equivalent transistor shaped like a diode, and in an embodiment of the present invention equal to the difference of the threshold voltage of the used transistors in the circuit disposal, they have great advantages in all the circuits in which a lower voltage threshold with respect to the lower one offered by the used building process.

The features and the advantages of the present invention will be made evident by the following detailed description of its preferred embodiment, illustrated as a non-limiting example in the annexed drawings, wherein:

figure 1 shows a MOS transistor of p type shaped like a diode according to the known art;
figure 2 shows a MOS transistor of n type shaped like a diode according to the known art;
figure 3 shows a circuit disposal comprising a MOS transistor of p type according to a first embodiment of the present invention;
figure 4 shows a circuit disposal comprising a MOS transistor of n type according to a second embodiment of the present invention;
figure 5 shows a circuit disposal comprising a MOS transistor of p type which is not part of the present invention;
figure 6 shows a circuit disposal comprising a MOS transistor ofn type which is not part of the present invention.

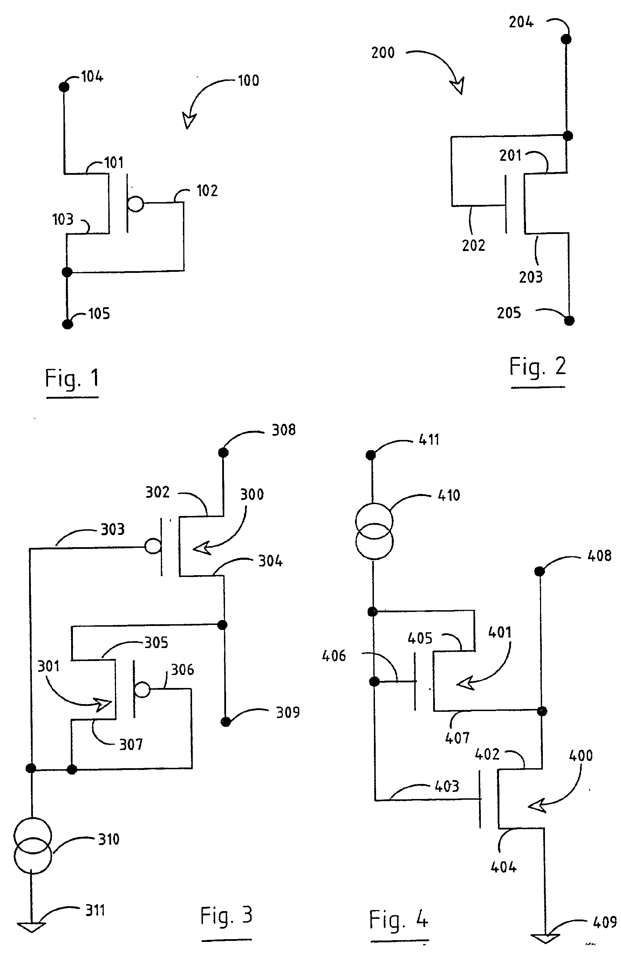

In figure 1 a pMOS transistor 100 has the shape of a diode. It has a gate terminal 102 connected to a drain terminal 103 and to an external terminal 105 to which it is applied a voltage VB. The transistor 100 has also a source terminal 101 connected to an external terminal 104 to which is applied a voltage VDD. For the working of the circuit the voltage VB must be lesser than voltage VDD less the threshold voltage of the transistor 100. The voltages VB and VDD can be also any internal voltage of the device In figure 2 a nMOS transistor has the shape of a diode. It has a gate terminal 202 connected to a drain terminal 201 and to an external terminal 204 to which is applied a voltage VAA The transistor 200 has also a source terminal 203 connected to an external terminal 205 to which is applied a voltage VBB. For the working of the circuit the voltage VAA must be greater than voltage VBB less the threshold voltage of the transistor 200. The voltages VAA and VBB can be also any internal voltage of the device. In these two configurations, at the two external terminals of the transistors 100 and 200, the behaviour is equal to those of two diodes having a threshold voltage equal to the transistors themselves. Clearly, under said voltage threshold the devices are turn off.

For example, the transistor 100, having a threshold voltage VT1, stays in conduction if

$$VB < VDD - VT1$$

In analogous way the transistor 200, being VAA and VBB the generic voltages applied respectively on the drain and on the source, is in conduction if

$$VBB < VAA - VT1$$

In figure 3 an embodiment of the present invention is shown.

A pMOS transistor 300 having a source 302 connected to an external terminal 308 to which is applied a voltage VDD, a drain 304 connected to an external terminal 309 to which is applied a voltage VB, and a gate 303 connected to the drain terminal 307 and the gate 306 of another pMOS transistor 301. The source terminal 305, of the transistor 301, is connected to the drain terminal 304 of the transistor 300. The gate 303 is also connected to a current generator 310 terminal, the other terminal of the current generator 310 is connected to the external terminal 311 connected to the voltage VNN (in the figure it is connected to the ground terminal).

In practice the circuit disposal of figure 3, makes provision for a first transistor 300 having a second transistor 301, connected as diode, placed between the gate 303 (cathode of the diode) and the drain 304 (anode of the diode) of the first transistor 300 and a current generator having a terminal connected to the two gates 303 and 306 of the two transistors 300 and 301. The equivalent diode is that seen from the external terminals 308 and 309.

By means of using a process which makes provision for the possibility to build transistors having different thresholds (for example at low voltage and at high voltage) it is possible to achieve an equivalent transistor shaped like a diode with a threshold equal to the difference of the thresholds of the used transistors.

The transistor 300 has associated a threshold VT2 and the transistor 301 has associated a threshold VT1. The threshold voltage VT2, in absolute value, is greater than the threshold voltage VT1. With the circuit disposal shown in figure 3 it is obtained an equivalent transistor shaped like a diode having a threshold voltage equal to VT2 - VT1.

When the potential VB applied to the terminal 309 increases, increases also the potential VA of the gate terminal 303 and it is equal to VB - VT1, that is

$$VA = VB - VT1$$

The transistor 300 stays in conduction until

$$VDD - VA - VT2 > 0$$

which becomes

$$VDD - (VB - VT1) - VT2 > 0$$

from which

$$VB < VDD - (VT2 - VT1)$$

which compared with the equivalent relation relevant to the transistor 100, and that is

$$VB < VDD - VT1$$

to note as in the case of figure 3 it is obtained an equivalent transistor with lower threshold and equal to the difference of the threshold voltage of the two transistors.

Therefore choosing opportunely the threshold voltages of the two transistors it is possible to obtain a threshold voltage value prefixed and included between 0 and the maximum threshold obtainable with the used process.

The transistor 300 stays in saturation as long as the current generator 310 is dimensioned as to maintain the transistor 301 in conduction, satisfying the saturation condition of the transistor 300 which is

$$VB-VA<VT2$$

where VB - VA is almost equal to a VT1 if the current generator310 is opportunely dimensioned, therefore seen that

$$VT2>VT1$$

the above written saturation condition is surely satisfied.

The current generator 310, connected to the VNN potential, supplies a current of the appropriate sign, to bias the transistor 301, so that it could be correctly in conduction.

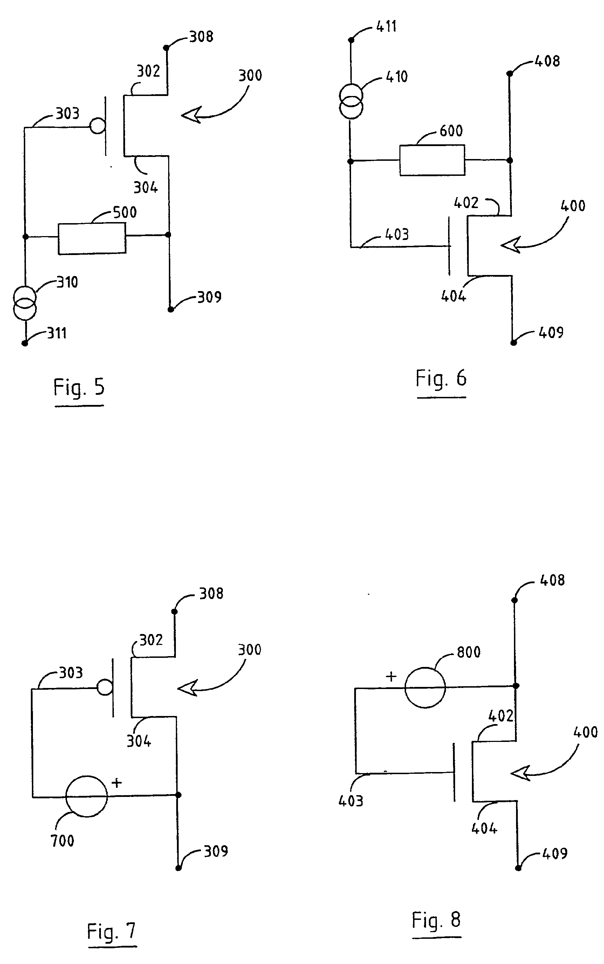

Such a circuital disposition results applicable also to MOS transistors of n type, as it can be seen in the figure 4.

A nMOS transistor 400 having a drain 402 connected to an external terminal 408 to which a voltage VA is applied, a source 404 connected to an external terminal 409 connected to a VBB potential (in the figure connected to the ground terminal), and a gate 403 connected to the gate terminal 406 and of drain 405 of an other transistor nMOS 401. The source terminal 407 of the transistor 401 is connected to a drain terminal 402 of the transistor 400. The gate 406 is also connected to a current generator terminal 410, the other terminal of the current generator 410 is connected to an external terminal 411 to which a voltage VPP is applied (with VPP > VA).

The transistor 400 has associated a threshold VT2 and the transistor 401 has associated a threshold VT1. The threshold voltage VT2 is bigger than the threshold voltage VT1.

Called VAA the voltage on the gate 403, the transistor 400 is in conduction if it is satisfied the following relation

$$VAA > VT2$$

which becomes

$$VT1 + VA > VT2$$

from which

$$VA > VT2 - VT1$$

Note that fixed the generic voltage VA on the external terminal 408, the equivalent diode (between the terminals 408 and 409) is in conduction until, being VBB the generic voltage on the terminal 409, is

$$VBB < VA - (VT2 - VT1)$$

The current generator 410, connected to the VPP potential, supplies a current of the opportune sign, to bias the transistor 401, so that it can be correctly in conduction.

Besides the transistor 400 works in a saturation zone being verified the condition

$$VDS > VGS - VT2$$

which becomes

$$VA > VT1 + VA - VT2$$

which is always verified if VT2 > VT1.

If VT1 is very close to VT2 the working point of the transistor 400 will be on the border between the saturation region and the triode region.

In the practical application of the configuration of the figure 3, the equivalent transistor shaped like a diode, having a lower threshold voltage, is that seen on the external terminals 308 and 309, biased so as to have the potential applied to the node 309 greater than the potential applied to the node 309.

In alternative to the transistor pMOS 301, connected as a diode and represented in the figure 5 by a block 500 connected to the terminals 304 and 303, it is possible to use a nMOS transistor connected as a diode (gate and drain connected to the terminal 304 and source connected to the terminal 303), or however a diode having its anode connected to the terminal 304 and its cathode connected to the terminal 303. Besides, it is possible to use a resistance of the opportune value, always applied between the nodes 304 and 303. The value of the resistance and of the current generator 310 must be determined so as to make fall the voltage value (VT1) on the resistance which will be subtracted from the transistor 300 voltage threshold.

In the practical application of the configuration of figure 4, the transistor equivalent shaped like a diode, having a lower threshold voltage is that seen from the external terminals 408 and 409, biased so as to have the potential applied to the node 408 greater than the potential applied to the node 409.

In alternative to the nMOS transistor 401, connected as a diode represented in figure 6 by a block 600 connected to the terminals 402 and 403, it is possible to use a pMOS transistor connected as a diode (gate and drain connected to the terminal 402 and source connected to the terminal 403), or however a diode having its anode connected to the terminal 403 and its cathode connected to the terminal 402 Besides, it is possible to use a resistance of the opportune value, always applied between the nodes 403 and 402. The value of the resistance and of the current generator 410 must be determined so as to make fall the voltage value (VT1) on the resistance which will be subtracted from the value of the transistor 400 voltage threshold

The circuit disposition of the shaped like a diode, is equivalent to that of the figure 7 and 8, in which a voltage generator, respectively 700 and 800, is connected in series to the gate transistors terminal 300 and 400 so as (voltage of opposite sign that of the threshold voltage) that the total voltage applied to the control terminal (gate) is lower than the threshold voltage of the transistor itself. That is the voltage generator operates a level translation between the gate control voltage and the voltage directly applied to the gate

The voltage generator, referring to the figure 5 and 6, includes respectively the block 500 and the 600 and the current generator 310 and 410.

**Claims**

1. Circuit disposal comprising a first MOS transistor (300, 400) having a gate terminal (303, 403) to which it is associated a first threshold voltage, a drain terminal (304, 402) connected to a first potential, a source terminal (302, 404) connected to a second potential, said circuit disposal comprising a diode connection transistor (301,401) of the MOS type and a current generator (310, 410) both having a respective terminal connected to said gate terminal (303, 403) of the first MOS transistors (300, 400) and said current generator having the other terminal (311, 411) connected to a third potential, said diode connection transistor (301, 401) having another gate terminal (306, 406), to which it is associated a second threshold voltage, connected with the gate terminal (303, 403) of the first MOS transistor (300, 400) and another terminal (305, 407) connected to a terminal (304, 402) of the first MOS transistor (300, 400), **characterized in that** said another terminal (305, 407) is the source terminal and is connected with the drain terminal of the first MOS transistor (300, 400) and **in that** said second threshold voltage has a value lower than the value of said first threshold voltage and is of the opposite sign to that of said first threshold voltage in a path between the gate and the source terminal of the first MOS transistor.

2. Circuit disposal according to claim 1, **characterized in that** said transistor (300) is of the p type

**3.** Circuit disposal according to claim 1, **characterized in that** said diode transistor (400) is of the n type.

**4.** Method for reducing the threshold voltage of a MOS transistor having a gate terminal to which it is associated a threshold voltage, said transistor having a drain terminal and a source terminal and said method comprising the application of a first and a second voltage respectively at the drain and source terminals said method comprising the application of a third prefixed voltage between the gate terminal and the drain terminal of said transistor, said third voltage being provided with a diode connection transistor and a current generator and comprising a further threshold voltage, **characterized in that** said further threshold voltage has opposite sign to that of said threshold voltage in a path between the gate and the source terminal of the first MOS transistor and the value of said further threshold voltage is lower than the value of said threshold voltage

**Patentansprüche**

**1.** Schaltungsanordnung mit einem ersten MOS-Transistor (300, 400) mit einem Gateanschluss (303, 403), welchem eine erste Schwellenspannung zugeordnet ist, einem an ein erstes Potential angeschlossenen Drainanschluss (304, 402), einem an ein zweites Potential angeschlossenen Sourceanschluss (302, 404), wobei die Schaltungsanordnung einen Transistor in Diodenschaltung (301, 401) vom MOS-Typ und einen Stromgenerator (310, 410) aufweist, die beide einen jeweiligen an den Gateanschluss (303, 403) des ersten MOS-Transistors (300, 400) angeschlossenen Anschluss haben und wobei der Stromgenerator der an ein drittes Potential angeschlossene Anschluss (311, 411) ist, wobei der Transistor in Diodenschaltung (301, 401) einen anderen Gateanschluss (306, 406), welchem eine zweite Schwellenspannung zugeordnet ist und der an den Gateanschluss (303, 403) des ersten MOS-Transistor (300, 400) angeschlossen ist, und einen an einen Anschluss (304, 403) des ersten MOS-Transistors (300, 400) angeschlossenen anderen Anschluss (305, 407) hat, **dadurch gekennzeichnet, dass** der andere Anschluss (305, 407) der Sourceanschluss ist und an den Drainanschluss des ersten MOS-Transistors (300, 400) angeschlossen ist, und dass die zweite Schwellenspannung einen Wert hat, der niedriger als der Wert der ersten Schwellenspannung ist, und in einem Pfad zwischen dem Gate- und dem Sourceanschluss des ersten MOS-Transistors das entgegengesetzte Vorzeichen zu demjenigen der ersten Schwellenspannung hat.

**2.** Schaltungsanordnung nach Anspruch 1, **dadurch gekennzeichnet, dass** der Transistor (300) vom p-Typ ist.

**3.** Schaltungsanordnung nach Anspruch 1, **dadurch gekennzeichnet, dass** der Diodentransistor (400) vom n-Typ ist.

**4.** Verfahren zum Reduzieren der Schwellenspannung eines MOS-Transistors mit einem Gateanschluss, welchem eine Schwellenspannung zugeordnet ist, wobei der Transistor einen Drainanschluss und einen Sourceanschluss hat, und wobei das Verfahren das Anlegen jeweils einer ersten und einer zweiten Spannung an den Drain- und den Sourceanschluss aufweist, wobei das Verfahren das Anlegen einer dritten zuvor festgelegten Spannung zwischen dem Gateanschluss und dem Drainanschluss des Transistors aufweist, wobei die dritte Spannung mit einem Transistor in Diodenschaltung und einem Stromgenerator geliefert wird und eine weitere Schwellenspannung aufweist, **dadurch gekennzeichnet, dass** die weitere Schwellenspannung in einem Pfad zwischen dem Gate- und dem Sourceanschluss des ersten MOS-Transistors ein entgegengesetztes Vorzeichen zu demjenigen der Schwellenspannung hat und der Wert der weiteren Schwellenspannung niedriger als der Wert der Schwellenspannung ist.

**Revendications**

**1.** Arrangement de circuit comprenant un premier transistor MOS (300, 400) possédant une borne de grille (303, 403) à laquelle est associée une première tension de seuil, une borne de drain (304, 402) connectée à un premier potentiel, une borne de source (302, 404) connectée à un deuxième potentiel, ledit arrangement de circuit comprenant un transistor connecté en diode (301, 401) du type MOS et un générateur de courant (310, 410) qui ont tous deux une borne respective connectée à ladite borne de grille (303, 403) du premier transistor MOS (300, 400), et ledit générateur de courant ayant son autre borne (311, 411) connecté à un troisième potentiel, ledit transistor connecté en diode (301, 401) ayant une autre borne de grille (306, 406) à laquelle est associée une deuxième tension de seuil, connectée à la borne de grille (303, 403) du premier transistor MOS (300, 400) et une autre borne (305, 405) connectée à une borne (304, 402) du premier transistor MOS (300, 400), **caractérisé en ce que** ladite autre borne (305, 407) est la borne de source et est connectée avec la borne de drain du premier transistor MOS (300, 400) et **en ce que** ladite deuxième tension de seuil est d'une valeur inférieure à celle de ladite première tension de seuil et est du signe opposé à celui de ladite première tension de seuil sur un trajet compris entre la borne de grille et la borne de source du premier transistor MOS.

2. Arrangement de circuit selon la revendication 1, **caractérisé en ce que** ledit transistor (300) est du type p.

3. Arrangement de circuit selon la revendication 1, **caractérisé en ce que** ledit transistor (400) monté en diode est du type n.

4. Procédé permettant de réduire la tension de seuil d'un transistor MOS possédant une borne de grille à laquelle est associée une tension de seuil, ledit transistor possédant une borne de drain et une borne de source et ledit procédé comprenant l'application d'une première tension et d'une deuxième tension respectivement à la borne de drain et à la borne de source, ledit procédé comprenant l'application d'une troisième tension préfixée entre la borne de grille et la borne de drain dudit transistor, ladite troisième tension étant prévue avec un transistor connecté en diode et un générateur de courant et comprenant une autre tension de seuil,
**caractérisé en ce que** ladite autre tension de seuil possède un signe opposé à celui de ladite tension de seuil sur le trajet compris entre la borne de grille et la borne de source du premier transistor MOS et la valeur de ladite autre tension de seuil est inférieure à celle de ladite tension de seuil.

Fig. 1

Fig. 2

Fig. 3

Fig. 4

Fig. 5

Fig. 6

Fig. 7

Fig. 8